# EUROPEAN PATENT APPLICATION

(11) **EP 4 344 958 A1**
(43) Date of publication of application: **03.04.2024**
(21) Application number: 23198593.8
(22) Date of filing: 20.09.2023
(51) Int. Cl.: B60R 11/04, B60Q 1/00, G02B 19/00, G03B 17/55, G03B 17/56, G08B 13/196, H04N 23/51, H04N 23/55, H04N 23/56, H04N 23/57, H04N 23/81

(54) **VEHICLE SAFETY DEVICE**

(30) Priority: 26.09.2022 US 202217952573
(71) Applicant: Cambridge Mobile Telematics Inc., Cambridge, MA 02142 (US)
(72) Inventor: LIGGETT, Melinda, Cambridge, 02142, MA (US); KAMADA, Isaku, Cambridge, 02142, MA (US); LINK, Nathan Thomas, Cambridge, 02142, MA (US); WISE, Joshua, Cambridge, 02142, MA (US)
(74) Representative: Fish & Richardson P.C.

(57) **Abstract**

This disclosure relates to a vehicle camera system. In some examples, the vehicle camera system includes one or more camera components, heat generating electronic components, and a shroud. The shroud is configured to provide structural support for the one or more camera components and configured to facilitate dissipation of heat generated by the heat generating electronic components. In some examples, the shroud includes boundaries at least partially surrounding the heat generating electronic components and defining a heat dissipation path for air flow from at least one air inlet to an air outlet of the shroud, and mounting features for mounting the one or more camera components, in which at least one of the mounting features is defined within a portion of the boundaries defining the heat dissipation path.

## Description

### TECHNICAL FIELD

This description relates generally to a device for vehicle safety and, in particular, a device configured to improve safety for vehicles and users of the vehicles.

### BACKGROUND

In general, a vehicle safety device can capture and, in some cases, analyze data associated with a vehicle, its passengers, and other objects in the vehicle's environment (e.g., other vehicles, pedestrians, and cyclists, among others). For example, vehicle cameras (sometimes referred to as "dashboard cameras" or "dashcams") can include sensors configured to capture image and video data within a vehicle and/or its surrounding environment. This image and video data can then be used for a variety of purposes including, for example, safety and evidentiary purposes.

### SUMMARY

In general, this specification describes a vehicle safety device that includes one or more sensors configured to produce sensor data at the vehicle. The device includes various mechanical aspects designed to improve the quality of sensor data capture, maintain suitable states for one or more sensors, and capture sensor data at various poses.

For example, the techniques described in this specification can improve the quality of sensor data collected by one or more sensors included in a device. More specifically, a device implementing the described techniques can include a component, sometimes referred to as a shroud, which is configured to secure one or more sensors, among other electrical and mechanical components. The shroud is directly connected to or mechanically coupled with a mounting mechanism configured to attach the device to a vehicle. This arrangement can substantially reduce undesired vibration of the sensors and other components of the device caused by the vehicle, thereby improving sensor data quality.

The techniques described in this specification can also improve functioning and expand the lifespan of a device and components included in the device. More specifically, a device implementing the described techniques can include a heat dissipation path for air flow, one or more heatsink elements disposed along the heat dissipation path, and one or more fans located in the heat dissipation path to drive air flow. The heat dissipation path is designed to efficiently maintain a suitable range of internal temperature of the device, which can ensure that the device and its components (e.g., electronics or other heat-generating components) operate at a proper temperature to avoid malfunction and failure due to overheating. In this manner, the described techniques expand the range of temperatures over which the device and its components will work and increase their lifespan. Configuring the device as described herein also has the benefit of improving ease of assembly during the manufacturing process.

In addition, the techniques described in this specification can provide robust and versatile fields of view for sensors to capture sensor data. More specifically, a device implementing the described techniques can robustly adjust a pose of at least a portion of the device or one or more sensors secured in the device. The techniques can provide stability for collecting sensor data by preventing an undesired change of poses of the device or the sensors of the device (e.g., due to vibrations of the vehicle or shock to the vehicle). The techniques can allow multiple adjustments of poses of the device and sensors of the device given an external torque or force above a threshold value. The threshold value is adjustable by an adjusting element of the device. The device can adjust the field of view for one or more sensors by adjusting the pose of the device or its sensors, which can provide the device with multiple ranges and angles for robustly collecting sensor data.

Furthermore, the techniques described in this specification are suitable for collecting sensor data in different environments. More specifically, a device implementing the described techniques can collect high-quality sensor data even in environments where the ambient light is low. For example, in some implementations, light emitted from automotive headlights can be collected from the exterior of a vehicle in the evening or while in the interior of a parking structure or tunnel. In some implementations, the device can include one or more illuminators, such as infrared (IR) illuminators configured to emit light in the infrared spectrum, which are suitably located and secured in the device. The illuminators can eject light beams to be reflected by objects and collected by one or more sensors to collect sensor data in different environments, for example, even when the interior or exterior of a vehicle is dark. The allocations of the illuminators in the device and the structure of the device described in this specification can avoid light flare and other light piping effects, thereby enhancing the quality of collected sensor data.

In an aspect, a vehicle camera device or system includes one or more camera components, heat generating electronic components, and a shroud configured to provide structural support for the one or more camera components and configured to facilitate dissipation of heat generated by the heat generating electronic components, the shroud including: boundaries at least partially surrounding the heat generating electronic components and defining a heat dissipation path for air flow from at least one air inlet to an air outlet of the shroud; and mounting features for mounting the one or more camera components, in which at least one of the mounting features is defined within a portion of the boundaries defining the heat dissipation path.

Implementations may include one or a combination of two or more of the following features.

In some implementations, the vehicle camera device or system includes an enclosure configured to house the shroud, in which the shroud is separated from at least a portion of an inner surface of the enclosure by a gap. The gap separating the shroud and the inner surface of the enclosure can form at least a portion of the heat dissipation path.

In some implementations, the at least one air inlet is located on a first region of the shroud, and the air outlet is located on a second region below a connecting member of the shroud, and an enclosure configured to house the shroud includes one or more venting apertures configured to cover at least a portion of the least one air inlet and air outlet to allow air flow through.

In some implementations, the vehicle camera device or system includes a windshield mount configured to attach the vehicle camera system to a windshield of a vehicle. The windshield mount can be coupled to the shroud through a coupling mechanism that includes a first connecting element located on the shroud and configured to couple with a second connecting element located on the windshield mount.

In some implementations, the vehicle camera device or system includes a fan configured to drive the air flow along a direction from the at least one air inlet to the air outlet along the heat dissipation path. The fan can be disposed in a cavity of the shroud and located adjacent to the air outlet of the shroud.

In some implementations, the shroud surrounds one or more heatsink elements disposed in a respective cavity defined in the shroud along the heat dissipation path, in which the one or more heatsink elements are configured to distribute heat produced by the heat generating electronic components.

In an aspect, a vehicle camera device or system includes a support structure configured to hold one or more image sensors, a windshield mount, and a connecting member configured to couple the support structure to the windshield mount in multiple possible orientations of the support structure relative to the windshield mount. The connecting member can include a first connecting element located on the support structure, a second connecting element located on the windshield mount configured to couple with the first connecting element, and a locking element configured to resist a change in an orientation of the support structure relative to the windshield mount. The vehicle camera device or system can further include an adjusting element configured to adjust a threshold torque value for resisting the change in an orientation of the support structure relative to the windshield mount from one of the multiple possible orientations to another of the multiple possible orientations.

Implementations may include one or a combination of two or more of the following features.

In some implementations, the support structure is inside a housing covering the support structure, in which the support structure is separated from at least a portion of an inner surface of the housing by a gap.

In some implementations, the locking element is a friction-based locking mechanism.

In some implementations, the locking element includes a first locking component arranged at the first connecting element, and a second locking component arranged at the second connecting element, in which the first and second locking components are configured to engage to rotationally lock the first and second connecting elements with the threshold torque value. The first locking component can include first teeth and the second locking component can include second teeth, in which the first teeth and the second teeth are configured to engage to form a clutch-type engagement that rotationally locks the first and second connecting elements with the threshold torque value.

In some implementations, the adjusting element includes a knob with one or more extrusions extending from an outer surface of the adjusting element, in which the knob, when rotated, is configured to change a pressure applied on the first connecting element and the second connecting element to permit changing of the threshold torque value for rotating the first connecting element relative to the second connecting element.

In some implementations, the first connecting element includes a first inner opening, the second connecting element includes a second inner opening, and at least one of the first and second inner openings includes a first thread configured to interface with a second thread of a lead screw of the adjusting element to form a threaded interface. In some implementations, the knob, when rotated, is configured to drive the lead screw along an axial direction of the lead screw relative to the first and second inner openings through the threaded interface. In some implementations, the adjusting element is configured to adjust the pressure applied on the locking element based on a relative axial position of the lead screw and the first and second inner openings through the threaded interface.

In some implementations, the adjusting element includes a nut having at least one extrusion extending radially outward at an end of the nut, in which the at least one extrusion of the nut is configured to couple with at least one aperture of a knob.

In an aspect, a vehicle camera device or system includes an image sensor, one or more light sources, and an enclosure configured to house the one or more light sources and the image sensor, the enclosure including: a central opening located on the enclosure and configured to pass light to the image sensor; and one or more surrounding openings located at an outside periphery of the central opening on the enclosure, in which each of the one or more surrounding openings is configured to pass a respective light beam generated by at least one of the one or more light sources, and in which at least one of the one or more surrounding openings has a fillet or chamfer on an external surface of the enclosure, the fillet or chamfer forming an inner edge of the at least one surrounding opening that does not interfere with a light beam generated by a corresponding light source of the one or more light sources.

Implementations may include one or a combination of two or more of the following features.

In some implementations, the one or more surrounding openings are arranged to prevent respective light beams generated by the one or more light sources from being reflected into a field of view of the image sensor through the central opening.

In some implementations, the one or more light sources are infrared (IR) light-emitting diodes (LEDs).

In some implementations, the one or more surrounding openings include four surrounding openings, each having a diameter smaller than a diameter of the central opening.

In some implementations, the vehicle camera device or system further includes an array of openings located above the central opening closer to another end of the enclosure, in which the array of openings each are configured to receive a respective control button for controlling the vehicle camera system.

In some implementations, the one or more sensors of the device include a camera. The camera can be an inward-facing camera positioned to capture one or more images of an interior of the vehicle. The inward-facing camera can be positioned to capture the one or more images of both a front seat and a rear seat of the vehicle. The camera can be an outward-facing camera positioned to capture the one or more images of an area exterior to the vehicle. The camera can be arranged in different positions and/or orientations, and adjustable to move from one position or orientation to another position or orientation. The camera can be configured to zoom in or zoom out in response to the one or more signals. The camera can include an infrared (IR) camera. The camera can include an illuminator (e.g., an IR illuminator, a visible light illuminator, or another illuminator) configured to illuminate an area within the view of the camera. The camera can include a wide-angle lens.

In some implementations, the device can be configured to be attached to the vehicle. In some implementations, the device can include a permanent adhesive or a semi-permanent adhesive for attachment within the vehicle. In some implementations, other attachment methods can be used, including, for example, a magnetic plate, clips, or screws/bolts.

The details of one or more embodiments of the subject matter of this specification are set forth in the accompanying drawings and the description below. Other features, aspects, and advantages of the subject matter will become apparent from the description, the drawings, and the claims.

### BRIEF DESCRIPTION OF THE DRAWINGS

FIG. 1A is a left perspective view of an example device.
FIG. 1B is a right perspective view of an example device.
FIG. 2A is a left perspective view of an example shroud.
FIG. 2B is a right perspective view of an example shroud.
FIG. 2C is a side view of an example shroud assembled with an example left portion of a housing of a device.
FIG. 3A is a left respective view of an example windshield mount of a device.
FIG. 3B is a perspective view of an example adjusting element of a device.
FIG. 3C is an exploded view of an example adjusting element.
FIG. 4A is a front view of a portion of an example housing of a device.
FIG. 4B is a zoomed-in back view of a portion of an example housing of a device.
FIG. 4C is a zoomed-in cross-sectional right view of a portion of an example housing of a device.
FIG. 5 is a schematic view of an example light resource located in an example surrounding an opening.
FIG. 6A is a right perspective view of a portion of an example housing of a device.
FIG. 6B is a left perspective view of a portion of an example housing of a device.
FIG. 6C is a zoomed-in left perspective view of an example button hatch.

Like reference numbers and designations in the various drawings indicate like elements.

### DETAILED DESCRIPTION

A vehicle safety device can be used to monitor driving behavior and other information at a vehicle in order to, for example, recognize situations that put the safety of the vehicle or its users at risk. To facilitate this analysis, the device can include one or more sensors configured to produce sensor data for analysis. The one or more sensors can include, for example, image sensors, audio sensors, accelerometers, or gyroscopes, among other sensors. The device can also include one or more processing devices (e.g., CPUs or GPUs, or both) and memory with program instructions for analyzing the sensor data locally. In this way, the device can identify situations that put the safety of the vehicle or its users at risk faster and with reduced reliance on a network connection relative to systems that use a remote processing device to conduct such analysis. In some examples, the device can also include network components (e.g., Bluetooth, Wi-Fi, and/or cellular transceivers, among others) to communicate the analysis and/or the sensor data itself to a remote processing device for further analysis.

The above-noted sensors, processors, and other electronics are typically arranged and secured into a package of the device. However, these electronics can generate a significant amount of heat within the limited space of the package, which can cause these electronics to malfunction or become irreversibly damaged, especially when the vehicle's internal temperature is high or the device is exposed directly to a heat source (e.g., sunlight).

In addition, a vehicle safety device is typically located or mounted at a position in the vehicle that allows for consistent collection of sensor data for analysis. For example, a device can be adhesively attached to the windshield of a vehicle, or integrated into a control panel of the vehicle. As a result, the device can be subject to significant vibration due to, for example, rough road conditions or the vehicle's engine, which can negatively impact the quality of data collected by the sensors.

The present disclosure provides a vehicle safety device configured to maintain the advantages of having multiple types of sensors, processing devices, and network components, while preventing these electronics from being overheated and reducing the effects of the vehicle vibration on data quality. In accordance with an aspect of the present disclosure, the vehicle safety device includes a shroud that is configured to secure the sensors and processing devices and is coupled with a mounting mechanism (e.g., a windshield mount). In this way, the sensors and processing devices are coupled with the mount only through the shroud and without additional components in between, which can reduce the transmission of vehicle vibrations to the components. The shroud also includes internal edges and boundaries that at least partially surround these sensors and processing devices. These internal edges and boundaries further define at least one heat dissipation path. The shroud is configured to facilitate dissipation of heat along the at least one heat dissipation path for air flow from an air inlet to an air outlet of the shroud. As a result, the ambient temperature for these electronics can be maintained within a suitable range for proper functioning, and the overall temperature range over which the device works can be expanded.

In some examples, the shroud is coupled with the mounting mechanism through a connecting member, which further improves the data quality by allowing adjusting different poses of the sensors to change a field of view and an observing region of the sensors. The connecting member is also configured to prevent changing sensor orientations due to undesired vibrations.

In some examples, the vehicle device also includes multiple surrounding openings that compensate light sources to generate high-quality sensor data even under low ambient light conditions. The surrounding openings are particularly constructed to reduce and even eliminate image distortions due to light flare, which further enhances the sensor data quality.

The term "vehicle safety device" refers broadly to any suitable device that includes one or more sensors configured to collect sensor data at a vehicle. For example, the "vehicle safety device" can include a telematics device, a mobile device, or another device with one or more sensors configured to collect image data, video data, audio data, telematics data, or combinations of them, among other data. In some examples, a vehicle safety device can further include one or more processing devices (e.g., processors) to process the collected sensor data, or one or more transmission units configured to transmit the collected sensor data to a remote processing device (e.g., a server) for analysis of the sensor data. A vehicle safety device can also include one or more mounting mechanisms (e.g., a windshield mount) configured to attach the device to a portion of a vehicle. For simplicity, the "vehicle safety device" is also referred to as a "safety device" or "device" throughout the specification.

In some examples, the device is a component of a "vehicle user safety technology." The term "vehicle user safety technology" (or simply the "safety technology" or the "technology") refers to a technology that enables personal safety concerns for users of vehicles to be indicated, identified, communicated, analyzed, or acted on (or combinations of them) to enhance the safety of vehicle users by, for example, making the users and other participants in the technology aware of the safety concerns and reducing the risks to the users associated with the safety concerns, among others.

The term "personal safety concern" described in this specification can broadly include, for example, any situation, event, occurrence, context, or scenario, in which the personal safety, such as the physical safety, of a user of a vehicle is compromised or potentially compromised. In some examples, the safety concern can rise to the level of "panic." The term "panic" can refer to such heightened safety concerns.

The term "vehicle" described in this specification can broadly include, for example, any kind of ground conveyance such as a car, truck, bus, bicycle, motorcycle, or recreational vehicle, among others.

The term "participant" described in this specification can broadly include, for example, any party that owns, uses, hosts, or participates in the technology, including drivers, passengers, or other occupants or users of vehicles, or third parties such as government agencies, insurance adjusters, ridesharing companies, emergency services, call centers, analysts, researchers, and hosts of the technology, and combinations of them.

The term "user" described in this specification can broadly include, for example, a driver, passenger, or other occupants of a vehicle, or a person who is to become or has recently been an occupant of the vehicle.

The term "telematics data" described in this specification can broadly include, for example, any kind of numerical or other information about vehicle motion, vehicle state, occupant state or behavior, or other information indicative of, associated with, produced by, or caused by a personal safety concern. Telematics data is typically captured at the vehicle at or by a source device and can be communicated by wire or wirelessly to another device at the vehicle or directly or indirectly to another device remote from the vehicle. Telematics data can include raw telematics data and derived telematics data. In some cases, telematics data includes information captured at the vehicle and processed or analyzed at the vehicle to derive other telematics data, such as derived telematics data or summary telematics data.

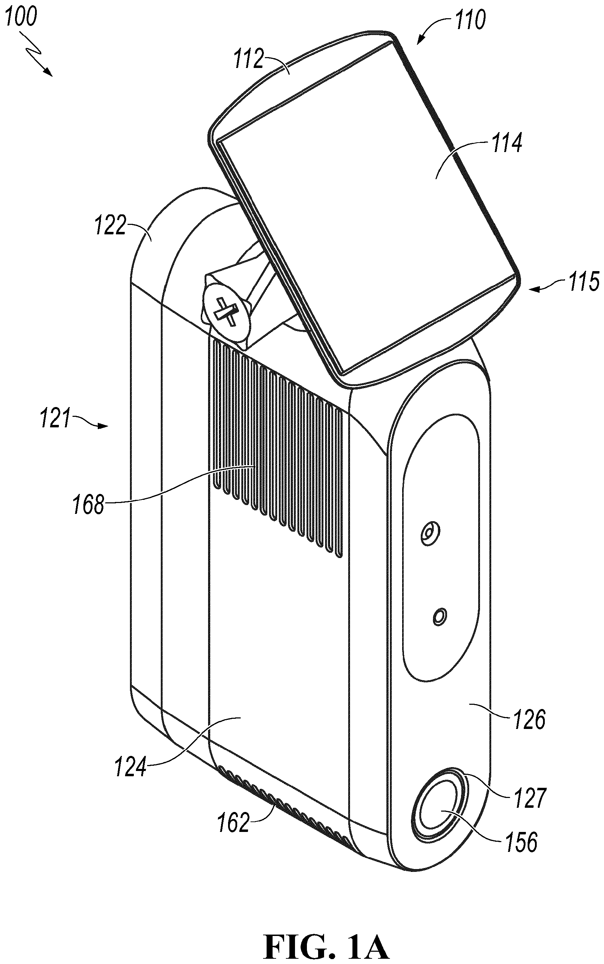

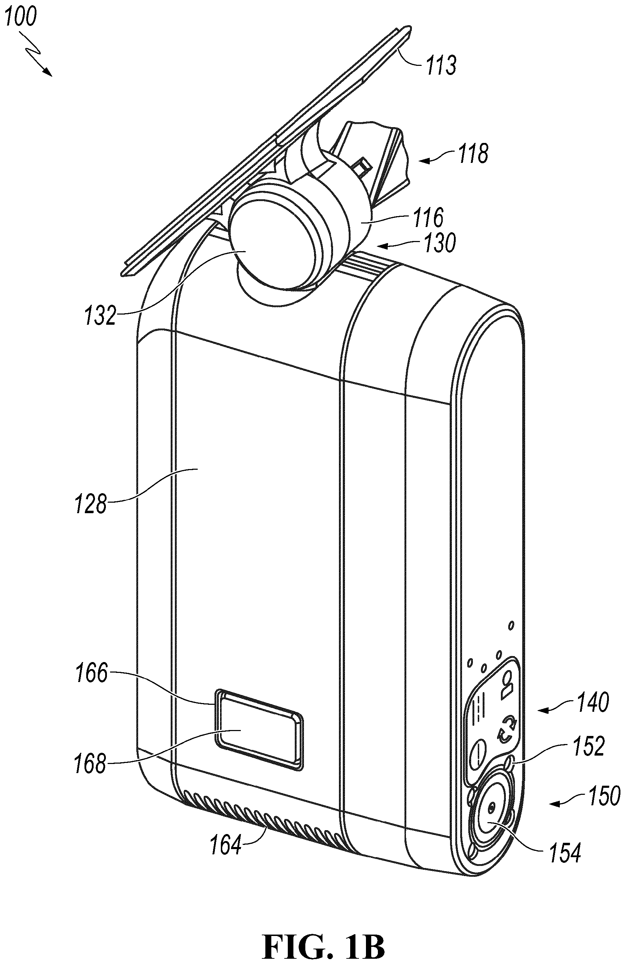

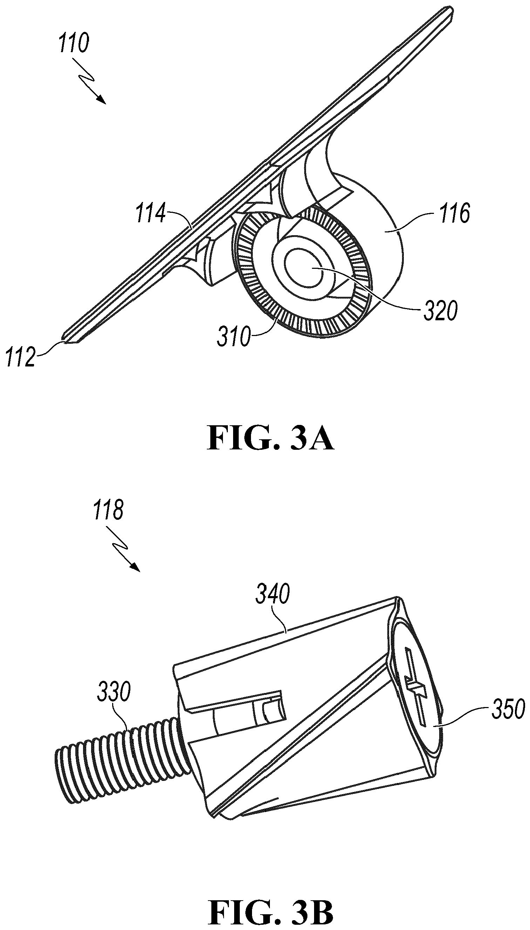

FIGS. 1A and 1B are left and right perspective views of an example device 100, respectively. As shown in FIGS. 1A and 1B, the device 100 can include a mount portion 110 and a main portion 120. The mount portion 110 and the main portion 120 can be mechanically coupled through a connecting member 130. The connecting member 130 can include, for example, a hinge or a clutch. The connecting member 130 is further coupled with an adjusting element 118 configured to adjust one or more mechanical properties of the connecting member 130. The details of the connecting member 130 and the adjusting member 118 will be described in connection with FIGS. 3A-3C.

Referring back to the mount portion 110, as shown in FIG. 1A, the mount portion 110 can include a plate portion 115 that includes both front surface 112 and a back surface face 113. The mount portion 110 can further include a layer of adhesive material 114 attached to the front surface 112. The layer of adhesive material 114 can have a size equal to or smaller than the area of the front surface 112. The adhesive material can include a permanent or semi-permanent adhesive or epoxy, which are adhesive to surfaces (such as ceramic, glass, or metal) to prevent tampering or unauthorized removal of the device 100 from a surface (e.g., a windshield). The layer of adhesive material 114, when properly attached to a surface and based on the size of the layer and the characteristics of the surface material that the layer is attached to, can provide a holding force sufficient to hold the device 100 during vehicle operation. In some implementations, the mount portion can instead include a magnetic plate, clips, or screws/bolts to secure the device 100 from a surface.

In some implementations, the plate portion 115 can further include a recess in the front surface 112. The recess (not shown) can have a floor with a top surface lower than the front surface 112. The recess can have a size covering a substantial region of the front surface 112. The mount portion 110 can have a layer of adhesive material 114 configured to be deposited in the recess, with a portion of the layer extending higher than and above the front surface 112.

The layer of adhesive material 114 can include multiple layers of different types of adhesive materials, for example, two, five, eight layers of two, three, and five different adhesive materials or layers of materials in different fiber orientations.

The mount portion 110 can further include a cover layer configured to protect the top surface of the layer of adhesive material 114, and is configured to be peeled off to expose the top surface of the layer of adhesive material 114 for mounting. The cover layer can be made of any suitable plastic material.

Referring back to the back surface 113 of the mount portion 110, as shown in FIG. 1B, the mount portion 110 can include a second connecting element 116 extending away from the back surface 113. The size of the second connecting element 116 reduces in size as proximity increases from the back surface 113, which can provide a strong and stable structure for the mount portion 110 when the mount portion 110 holds the main portion 120 through the connecting member 130. The details of the second connecting element 116 and the interaction between the second connecting element 115 with a first connecting element 132 included in the connecting element 130 will be described in connection with FIGS. 3A-3C.

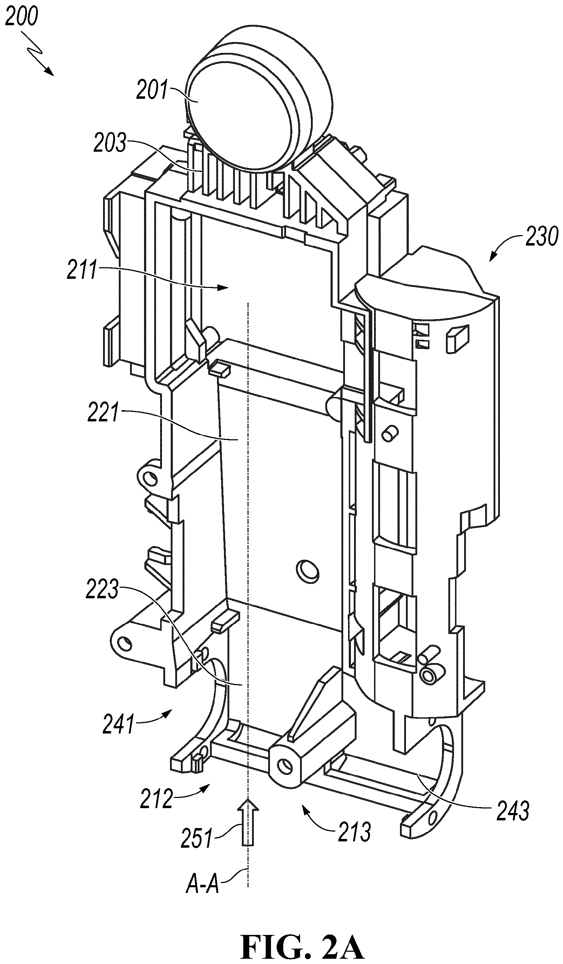

Referring back to the main portion 120, the main portion 120 can include a shroud 200 (as shown in FIG. 2A) configured to hold and secure one or more components, and a housing 121 configured to cover the shroud 200. The shroud 200 includes a first connecting element 132 configured to interact with the second connection element 114 of the mount portion 110 as described above. The structural aspect of the shroud 200 will be described in greater detail in connection with FIGS. 2A-2B.

The housing 121 of the main portion 120 (also called an enclosure) can include one or more portions configured to be assembled together. For example and as shown in FIGS. 1A and 1B, housing 121 can include a front portion 126, a back portion 122, a left portion 124, and a right portion 128. It should be appreciated that the total number of portions to assemble the housing 121 can be any suitable number and design. Different portions can overlap with each other and be assembled through pins and slots or screws.

The front portion 126 can include an aperture 127. The main portion 120 can secure an image sensor 156 inside the housing 121, and with the lens of the image sensor 156 being substantially concentric with the aperture 127. The image sensor 156 can receive light beams or reflected light beams from objects in a scene through the aperture 127. In some situations, the image sensor 156 can be a camera and is sometimes referred to as a front camera for the device 100.

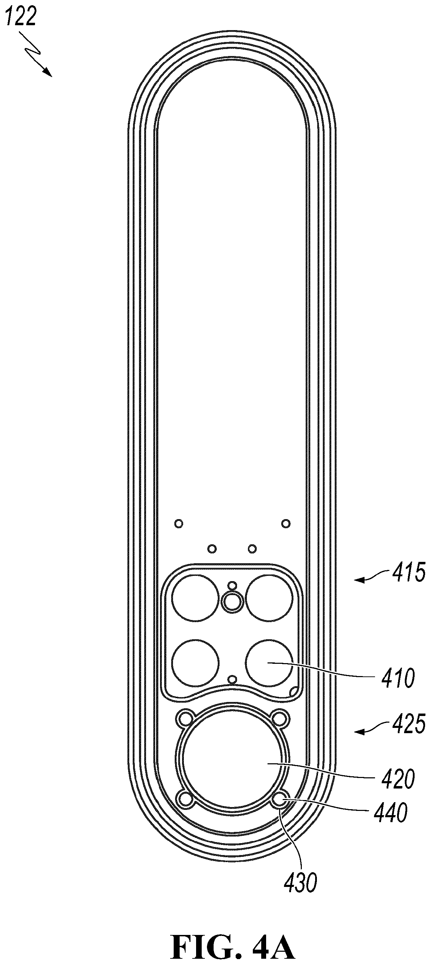

The back portion 122 can include a control panel 140 including one or more buttons configured to control the operations of the device 100. The back portion 122 can further include one or more apertures (not numbered) adapted for an optical assembly 150. The optical assembly 150 can include one or more illuminators 152 and an image sensor 154 secured inside the housing 120. The structural aspects of the back portion 122 and the optical assembly 150 will be described in greater detail in connection with FIGS. 4A-4C.

The left portion 122 can include one or more venting apertures configured to cover at least a portion of one or more air inlets and outlets formed inside the main portion 120 to allow air flow through. For example, the left portion 122 can include a first venting aperture 168 located in a top region of the left portion 122 and configured to cover an air outlet (not numbered). The left portion 122 can further include a second venting aperture 162 located in the bottom section of the left portion 122 and configured to cover at least a portion of an air inlet. The details of the air inlets and outlets will be described in connection with FIGS. 2A-2B.

Similarly, the right portion 128 can also include a third venting aperture located in a bottom region of the right portion 128 and configured to cover at least a portion of an air inlet. The venting apertures 164 and 162 can be referred to as venting apertures for air inlets.

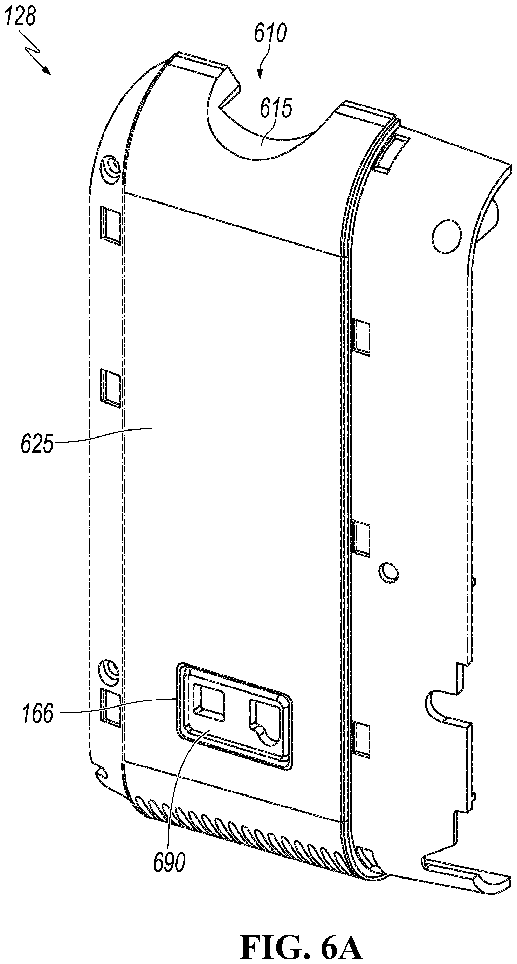

The right portion 128 can further include an aperture 166 configured to host a button hatch 168. The button hatch 168 can receive and secure one or more buttons configured to control testing of the device 100. The external surfaces of the one or more buttons and the button hatch can be recessed relative to the external surface of the right portion 128. The button hatch 168 can further include a lid (not numbered) with substantially the same size as the aperture 166 to cover the button hatch 168. In some implementations, the thickness of the lid can be equal to the level difference between the external surfaces of the button hatch and the external surface of the right portion 128. When the lid covers the aperture 166, the external surface of the lid and the external surface of the right portion 128 are at the same level and form an integral surface. The details of the button hatch 168 will be described in connection with FIGS. 6A-6C.

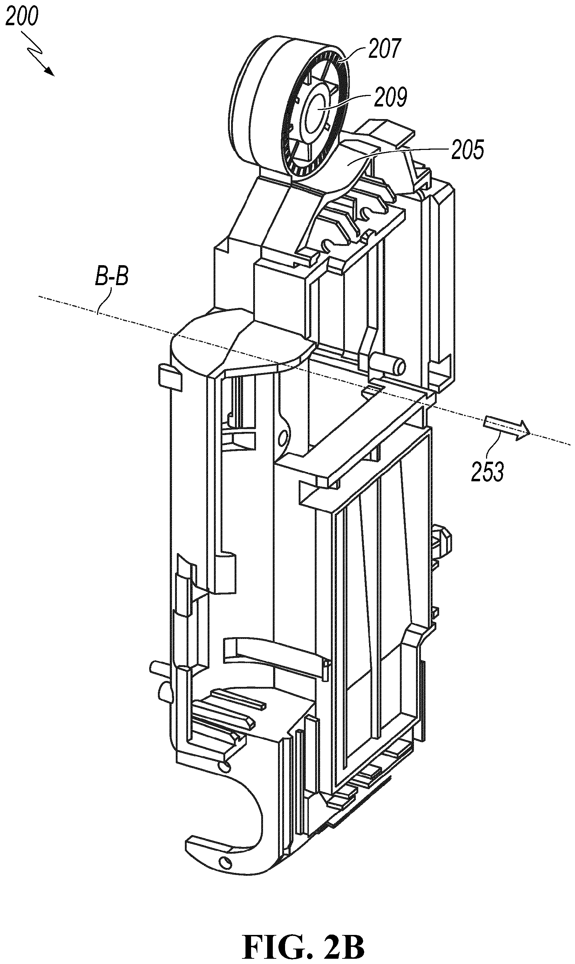

FIGS. 2A and 2B are left and right perspective views of an example shroud 200. As shown in FIGS. 2A and 2B, a shroud 200 can include one or more cavities to deposit and secure one or more components of the device 100. The shroud 200, therefore, can also be referred to as a support member or support structure, which is configured to support components of the device 200. The shroud 200 is dimensioned to be enclosed by the housing or enclosure 121.

The shroud 200 can include a neck portion 203 extending upward in a top region of the shroud 200. The neck portion 203 can be designed to fit in a top region of the housing. For example, the neck portion 203 can have a curved surface or an arc surface enclosed by corresponding portions of the left portion 124 and the right portion 128 of the housing 121.

The neck portion 203 can include the first connecting element 201 (equivalent to the first connecting element 132 of FIGS. 1A and 1B). The first connecting element 201 extends from a region of the neck portion 203. The rest region of the neck portion 203 can include a curved surface 205 dimensioned to receive the second connecting element 116 of FIGS. 1A and 1B.

The first connecting element 201 can be a cylindrical shell structure having an external circular surface and a side surface. The first connecting element 201 can further include a central hollow passage extending from the open side of the shell into the cavity formed by the cylindrical shell. The first connecting element 201 can further include a first locking component 207 adjacent to the inner periphery of the cylindrical shell.

Referring to FIG. 3A, the second connecting element 116 can have a corresponding shape similar or substantially the same as the first connecting element 201 (e.g., a cylindrical shell structure). The second connecting element 116 can also include a central hollow passage 320 extending from the open side of the shell into the cavity formed by the shell. The second connecting element 116 can further include a second locking component 310 configured to couple with the first locking component 207.

When the first and second connecting elements are assembled together, the first and second locking components 207, 310 form a friction-based locking mechanism configured to rotationally lock the first and second connecting elements. For example, the first locking component 207 can include multiple teeth, and the second locking component 310 can include multiple corresponding teeth configured to form an interlocking, clutch-type engagement with the teeth of the first component 207 in order to rotationally lock the first and second connecting elements. Other designs of the friction-based locking mechanism formed from locking components 207, 310 are also within the scope of the present disclosure. The details of the locking mechanism will be described in connection with FIGS. 3A-3C.

The shroud 200 can include an opening 211 below the neck portion 203. The opening 211 is configured to secure one or more fans (not shown) used to drive air flow. The opening 211 can also serve as a part of an air outlet. The opening 211 can be located under the first venting apertures of the housing 121 when the device 100 is assembled. In some examples, the opening 211 can be dimensioned according to the dimensions of a fan (e.g., the dimensions of an ingress or egress portion of the fan).

The shroud 200 can include a battery case 230 next to the opening 211. The battery case 230 can have an opening to receive one or more batteries, such as lithium-ion (Li+) batteries, as an energy source for the device 100 and/or one or more components of the device. To recharge the batteries, some examples of the device 100 can include one or more solar panels (not shown) affixed within a recess of the housing 121 and configured to receive sunlight or other light from outside the vehicle through the windshield. In some implementations, the device 100 can include an external power port (not shown), such as a USB-C port, and corresponding power circuitry to allow for a wired power connection to, for example, recharge the batteries or to provide system power when the charge of the one or more batteries are low or are not present. In some cases, the port can be used for data transfer to or from the device 100.

The shroud 200 can further include a region 221 below the opening 211 for depositing one or more components in the device 100. Some of the components are heat-generating components, e.g., electronics such as sensors configured to produce sensor data, integrated circuits that include controllers configured to control operations of the device 100, one or more processors configured to process collected sensor data, and one or more transmitters configured to transmit collected sensor data (e.g., raw telematics data) or processed sensor data (e.g., processed telematics data) between a server. The heat-generating components can also include subcomponents of sensors, one or more illuminators, and engines configured to drive a fan, among others.

Moreover, the shroud 200 can include (e.g., in addition to the region 221) one or more regions 223 to receive one or more image sensors. Regions 221 and 223 can further include multiple cavities defined by the shroud 200 and configured to receive one or more heatsink elements. The heatsink elements can be coupled to heat-generating electronic components and configured to distribute the heat produced by the components. As discussed below, the cavities formed for the heatsinks can be disposed in a heat dissipation path formed by the shroud to cool the heatsinks and the components they are coupled to.

The shroud 200 can include multiple mounting features 241 and 243 configured to secure corresponding image sensors in the regions 233 of the shroud 200. As shown in FIGS. 2A and 2B, the mounting features 241 and 241 can each include a flange to receive a corresponding image sensor. The flange is dimensioned to receive a particular region (e.g., a necking or a narrowed region) of an image sensor to secure it.

The shroud 200 can include one or more air inlets 212 and 213 in the bottom region of the shroud 200. The air inlets 212 and 213 are located under the second and third venting apertures 162 and 164 when the device 100 is assembled.

The shroud 200 can further define a heat dissipation path (e.g., 251 and 253 of FIGS. 2A and 2B). As described above, the shroud 200 can include one or more edges and boundaries that form the openings and cavities for depositing heat-generating components. After depositing the heat-generating components in the shroud 200, the boundaries of the shroud 200 can at least partially surround the heat-generating components, and further define a heat dissipation path for air flow from air inlets 212, 213 to an air outlet 211 of the shroud 200.

The shroud 200, when assembled, can cause a fan deposited in the air outlet 211 to pull air in from the one or more air inlets 212, 213 substantially along the A-A axis, and push air out from the air outlet 211 substantially along the B-B axis (or the opposite direction of the B-B axis, depending on the rotation direction of the fan). In some examples, the air flow through the device can be reversed (e.g., by configuring the fan to pull air in from the outlet 211 and push air out through the air inlets 212, 213). The air flow is driven by the fan along the heat dissipation path and facilitates heat exchange of the device 100 by, for example, pulling relatively cool air from the external environment over the components and the heatsinks to remove heat, and pushing the heated air out of the device 100 to decrease the internal temperature of the device 100.

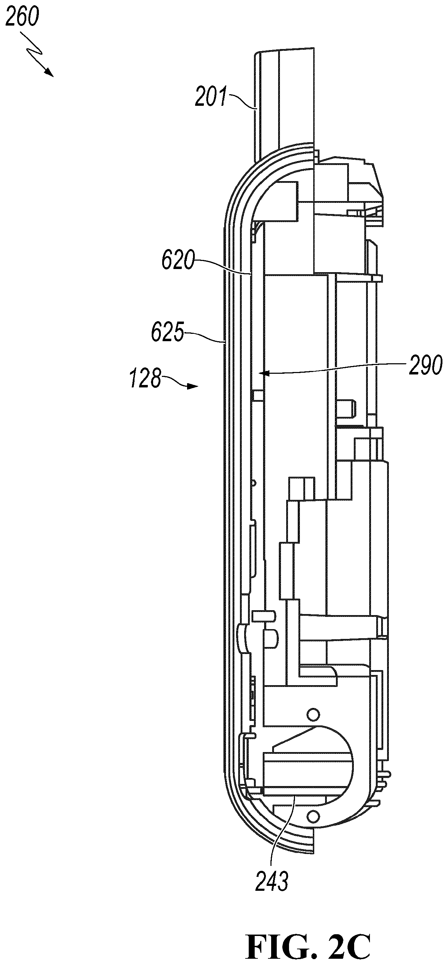

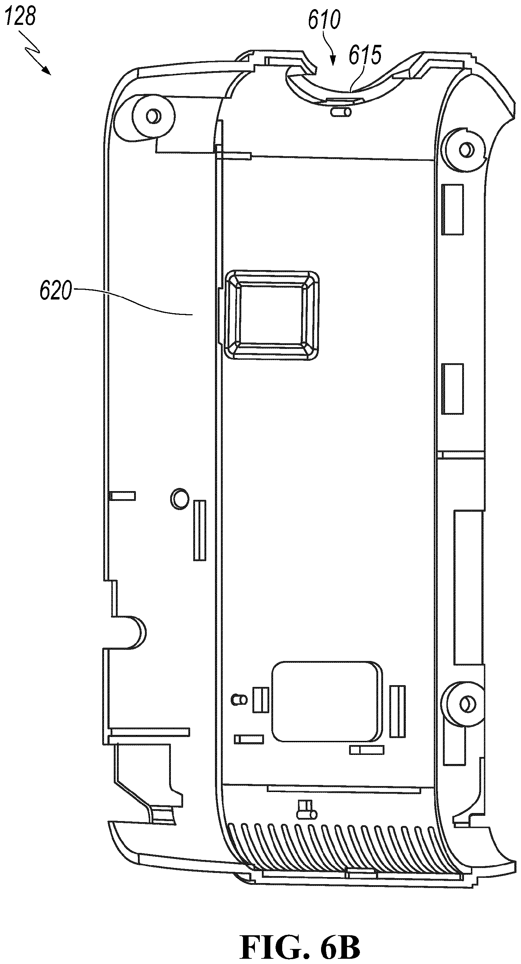

FIG. 2C is a side view of the example shroud 200 assembled with the example left portion 124 of a housing 121 of the example device 100. As shown in FIG. 2C and in connection with FIGS. 6A and 6B, the left portion 124 of the housing 121 can include an external surface 625 and an internal surface 620. When the left portion 125 is assembled with the shroud 200, the shroud 200 is separated from the inner surface 620 of the left portion 125 by a gap 290. The gap 290 can form at least a portion of the heat dissipation path (251 and 253 of FIGS. 2A and 2B).

FIG. 3A is a left respective view of an example windshield mount 110 of the example device 100. As described above, the second connecting element 116 can include a second locking component 310 corresponding to the first locking component 207 included in the first connection element 201. The first and second locking components can form a friction-based locking mechanism (e.g., a clutch engagement) to lock the relative rotation between the first and second connecting elements 116 and 201. In some examples, the first and second locking components 207, 310 can each include multiple corresponding teeth that engage to form an interlocking, clutch-type engagement.

In some examples, the second locking component 310 can be moved relative to first locking component 207 under a force or a torque greater than a threshold value. The threshold torque value can be adjusted by an adjusting element 118. Once a torque greater than the threshold value is applied to the second locking component 310 (or, alternatively, the first locking component 207), the main portion 120 and shroud 200 of the device 100 can be moved (e.g., rotated) relative to the mount portion 110. This enables the image sensors located inside the housing 121 of the device 100 to collect sensor data from different angles and fields of view when the main portion 120 is in different orientations relative to the mount portion 110.

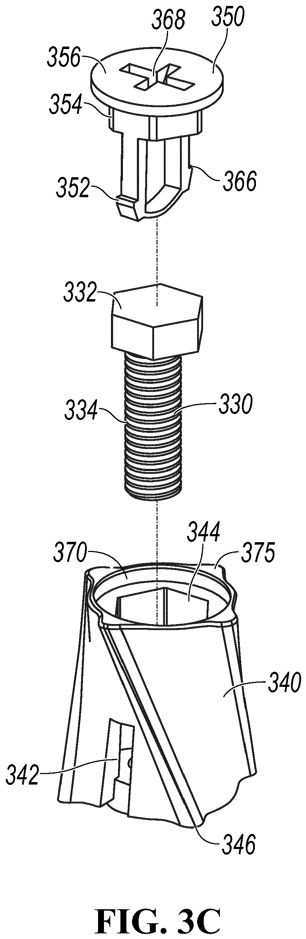

FIG. 3B is a perspective view of an example adjusting element 118 of the example device 100. FIG. 3C is an exploded view of the example adjusting element 118. As shown in FIG. 3B, the adjusting element 118 can include a leading screw 330, a knob 340, and a nut 350. The leading screw 330 can include a thread that corresponds to a corresponding thread located in the inner surface of the hollow passages 320 or 209, or both. The two threads can form a threaded interface to transform a rotational movement of the adjusting element 118 into an axial movement of the lead screw 300.

A user of the device can rotate the knob 340 of the adjusting element 118 to axially move an end portion of the leading screw 330 with respect to the hollow passages 320 and 209 through the threaded interface. The relative position of the end portion of the leading screw 320 relative to the hollow passages (e.g., a depth that the lead screw extends into the hollow passages) can determine a pressure value applied to the locking mechanism formed by the first and second locking components 207, 310, and thus the threshold torque value needed to move (e.g., rotate) the first locking component 207 with respect to the second locking component 310. The greater the pressure applied over the locking mechanism, the greater the threshold value and, thus, the greater the torque needed to move one of the locking components with respect to the other to adjust an orientation of the shroud 200 relative to the mount portion 110. A user can rotate the knob 340 in different directions to increase or decrease a threshold value.

In some implementations, the knob can include one or more extrusions 346 extending away from an outer surface of the knob. This can increase friction between a user's hand and the knob when the user rotates the knob. The extrusions can be suitably designed to have any geometries consistent with this specification. For example, as shown in FIG. 3C, the extrusions can be curved spline ridges.

The knob 340 includes an internal opening 344 adapted to receive the leading screw 330 and the nut 350. The internal opening 344 can have a size (e.g., an inner diameter) configured to receive a leading screw head 332 (e.g., an outer diameter) of the leading screw 330. The size of the internal opening 344 can further match the step 354 of the nut 350.

The knob 340 can further include a recess 370 above the internal opening 344, the recess 370 having a surface recessed relative to one end surface 375 of the knob 340. The recess 370 can have a depth and a substantially similar size as those of the step 354 of the nut 356. In this way, when the knob 340 receives the leading screw 330 and the nut 350, the outer surface 350 and the end surface 375 of the knob 340 can form an integral surface (e.g., the two surfaces are positioned in the same level as if they are a uniform or flat surface).

The nut 350 can include two arms 366 opposite to each other and extending away from the step 354 and unite at the farthest end from the step 354. The two arms each include an extrusion 352 located at the farthest end extending away from each other. The distance between the outer surfaces of the two extrusions 352 is greater than the size of the internal opening 344. Therefore, when the nut 350 is deposited into the internal opening 344, the two extrusions 352 and the arms 366 are deformed radially inward.

The nut 350 can include indentations 368 on the external surface 356. A user can use a screwdriver (or hand) with a matching tip corresponding to the indentations 368 to rotate the nut 350 relative to the knob 340. The knob 340 can include two side openings 342 to receive the two extrusions 352, respectively. The user can rotate the nut 350 to rotate the two extrusions 352 into the two side openings 342. Once the extrusions 352 are moved into the side openings 342, the knob 340 and nut 350 are rotationally locked.

When the adjusting element 118 is in the assembled state, the farthest end of the two arms 366 can contact the top surface of the leading screw head 332 to constrain axial movement of the leading screw 330 relative to the knob 340. Therefore a rotational movement of the knob 340 can cause the same amount of rotational movement of the leading screw 330 without axial movement relative to the knob. Thus, the rotational movement of the leading screw can be transformed into axial movement relative to the hollow passages 320 and 209 to apply a different pressure between the two connecting elements 116 and 201.

To disassemble the adjusting element 118, a user can apply a torque on the nut 350 using a screwdriver (or hand) to move the two extrusions 352 out of the side openings 342 and take out the nut 350 and the leading screw 330 from the knob 340. In some implementations, however, the extrusions 352 cannot be moved out of the side openings 342 once the two extrusions 352 are moved into the side openings 342 unless breaking the adjusting element 118.

FIG. 4A is a front view of a portion of an example housing 121 of the example device 100. As shown in FIG. 4A, the back portion 122 includes a first region 425 configured to receive an optical system (e.g., the optical system 150 of FIG. 1B), and a second region 415 configured to receive one or more control buttons in a control panel (e.g., the control panel 140 of FIG. 1B).

The optical system can include one or more light sources and an image sensor. As shown in FIG. 4A, one or more light sources can include illuminators 440 (e.g., light-emitting diodes (LEDs)). In some examples, one or more of the illuminators 440 are infrared (IR) illuminators that emit light in the IR spectrum, although other illuminators that emit light in other portions of the spectrum (e.g., visible light, ultraviolet light, etc.) can be used without departing from the scope of the present disclosure. The image sensor can be a camera configured to receive light reflected by an object in a scene (e.g., an interior of a vehicle).

The first region 425 of the back portion 122 can include a central opening 420 and one or more surrounding openings 430 located outside the central opening 420. The surrounding openings, for example and as shown in FIG. 4A, can be positioned equidistantly or separated by the same angle with each other. The device can include four surrounding openings 430 and four illuminators 440 each for a respective surrounding opening. The inner diameter of the surrounding openings 430 can be smaller than the central opening 420.

The image sensor is configured to be secured by the shroud 200 with the lens being substantially concentric to the central opening 420. The central opening 420 is configured to pass light to an image sensor, and the image sensor can collect the received light as sensor data and provide the sensor data for analysis at one or more processors in the device or transmit the sensor data to a server.

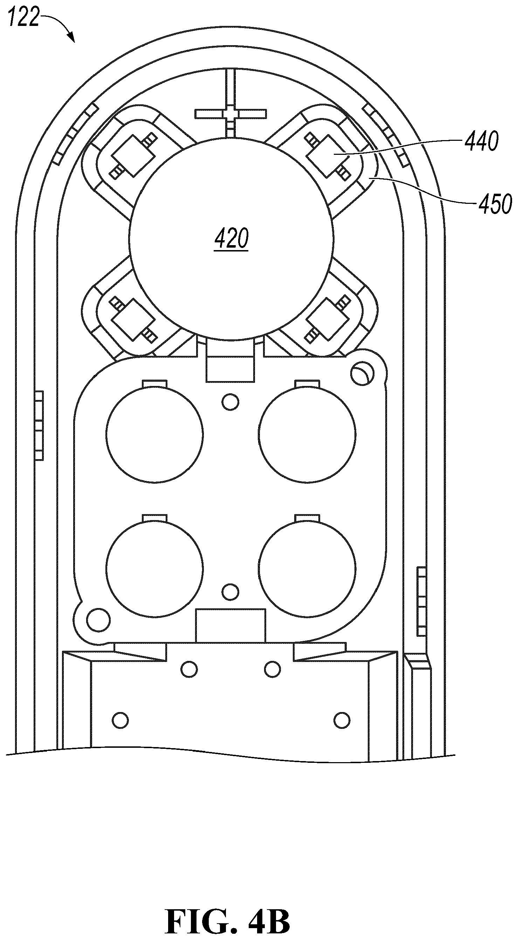

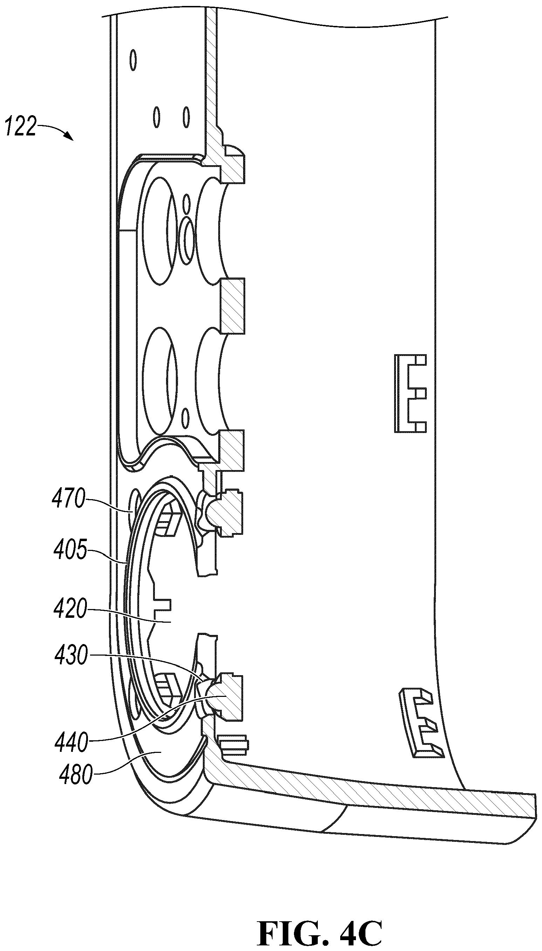

The one or more illuminators 440 are secured in the device and positioned concentrically with respective surrounding openings 430. The surrounding openings 430 are configured to pass a respective light beam generated by corresponding illuminators 440. The detailed design of the surrounding openings 430 will be described in connection with FIGS. 4B and 4C.

The second region 415 in the back portion 122 can include one or more openings 410 in an array configured to receive one or more control buttons in the control panel. The array can be a two-dimensional array as shown in FIG. 4A. The region 415 can further include a recess with a top surface lower than the external surface 480 of the back portion 122. The device 100 can include a cover with button symbols positioned in the recess. Each button symbol substantially covers a control button associated with a corresponding opening 410.

FIG. 4B is a zoomed-in back view of a portion of the example housing 121 of the example device 100. As shown in the back view of the back portion 12, the illuminators 440 are located in positions associated with the surrounding openings 430. Each surrounding opening 430 is located in a recess 450 formed on an inner surface of the back portion 122. The recess 450 allows the illuminators 440 to be positioned closer to the external surface 480 to help prevent interference between the back portion 122 and the light emitted by the illuminators 440, thereby avoiding light flare (e.g., IR flare).

FIG. 4C is a zoomed-in cross-sectional right view of a portion of the example housing 121 of the example device 100. As shown in FIG. 4C, the central opening 420 can have a ridge 405 at the outer diameter of the central opening 420. The ridge 405 extends away from the external surface 480 of the back portion 122.

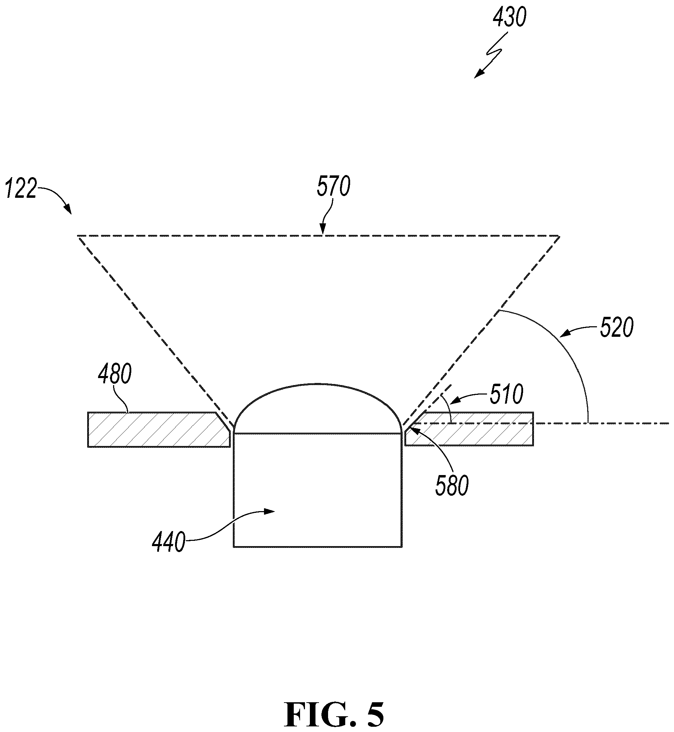

The surrounding openings 430 can be adjacent to the outer boundary of the ridge 405. Each surrounding opening 430 can include a fillet or chamfer 470 at the respective inner edge. The fillet or chamfer 470 extends from an external surface 480 of the back portion 122 throughout to an internal surface of the back portion 122. The fillet and chamfers 470 are dimensioned to ensure that the light beam generated from an illuminator 440 will not interfere with the inner edge of the chamfered surrounding openings 430. The details of avoiding interference will be described in connection with FIG. 5.

FIG. 5 is a schematic view of an example light resource located in an example surrounding opening 430. As shown in FIG. 5, an illuminator 440 (e.g., an IR LED) is positioned in a surrounding opening 430. The illuminator 440 can have a field of view 570. For example, the field of view 570 can cover an angle of view around 60 degrees. The fillet or chamfer 580 on the inner edge of the surrounding opening 430 can have an angle 510 with respect to the external surface 480 that is at least in parallel with the angle 520 of the conical boundary of the field of view 570 with respect to the external surface 480. In some implementations, the angle 510 of the fillet or chamfer 580 can be smaller than the angle 520 of the conical boundary of the field of view 570. For example, if the angle 520 is 60 degrees, then the angle 510 can be less than or equal to 60 degrees. In this way, the light beam emitted by the illuminator 440 and the field of view 570 of the illuminator will not intersect with the back portion 122. As a result, light flare (e.g., IR flare) and other light piping effects that can create artifacts in the images collected by the image sensor are prevented.

In some implementations, the size, location of the surrounding openings 430 and the fillet or chamfer 580 of the surrounding openings 430 are designed to prevent any light beam generated by the illuminator 440 from intersecting with the back portion 122 and creating artifacts in the images collected by the image sensor.

FIGS. 6A and 6B are a right and a left perspective view of a portion of a housing 121 of the example device 100, respectively. The right portion 128 can include a shoulder portion 615 with an opening 610 at the top of the right portion 128. As shown in FIGS. 6A and 6B and in connection with FIG. 2A, the shoulder portion 615 can include a curved surface compatible with the external surface of the first connecting element 201 of the shroud 200. The opening 610 is configured to enclose at least a portion of the neck portion 203 of the shroud 200.

As described above, the right portion 128 can include an external surface 625 and an internal surface 620. The right portion 128 can further include an opening 166 configured to receive a button hatch 690 for controlling test runs of the device 100.

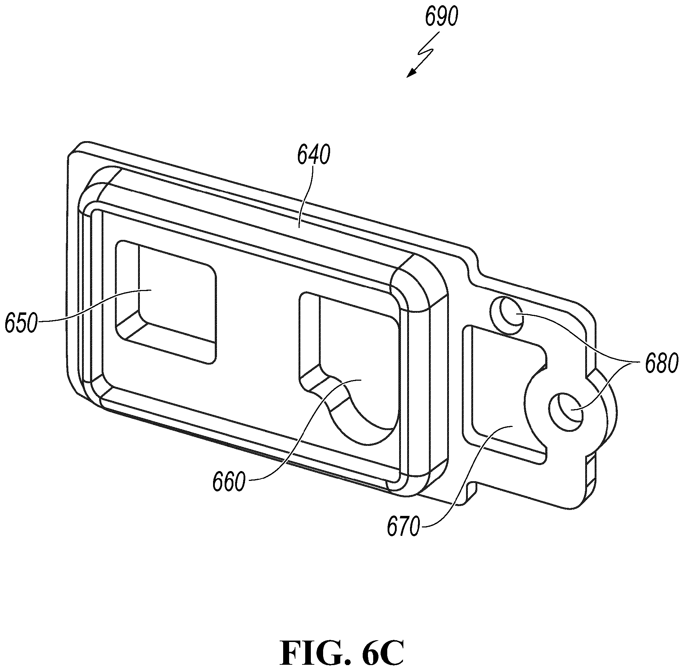

FIG. 6C is a zoomed-in left perspective view of an example button hatch 690. As shown in FIG. 6, the button hatch 690 can include one or more openings 650, 660, 670, 680. The openings 650 and 660 are formed in an extrusion 640. The extrusion 640 extends from the button hatch's surface and has a depth substantially the same as the thickness of the right portion 122. The openings 650 and 660 are configured to receive one or more control buttons configured to control test runs.

The openings 670 and 680 of the button hatch 690 are configured to secure the button hatch 690 to the right portion 128 of the housing 121. For example, the opening 670 can be configured to receive one or more extrusions extending away from the inner surface 620 of the right portion 128. The openings 680 are used for connecting the button hatch 690 to the right portion 128 through one or more screws or pins.

The described techniques can include one or more following embodiments.

The device can include multiple components, such as one or more processors, memory, network components (e.g., Bluetooth, Wi-Fi, and/or cellular transceivers), sensors, and a speaker. The housing includes one or more ventilation holes to allow for convection and sound transmission to and from the various components of the device. The housing includes a multipurpose button to, for example, power the device on or off, activate the device, and enable pairing, such as Bluetooth pairing, with the device, among others. In some implementations, the button can be surrounded by a light diffuser to indicate the status of the device, such as whether the device is powered on, whether the device is functioning properly, or whether the device is connected to another device.

The shroud can include and secure one or more cameras, including one or more inward-facing cameras (that is, a camera generally facing the inside of the vehicle when the video tag device is mounted on the windshield) positioned at a lower end of a rear side of the shroud to capture images, video, and audio of an interior of a vehicle, and one or more outward-facing cameras positioned at the opposite side of the shroud to capture images and video of an area exterior to the vehicle, such as the road.

In some implementations, the device 100 can include one or more illuminators, such as an IR light-emitting diode (LED), to illuminate the field of view of a camera (e.g., the inward facing camera).

While this specification contains many specific implementation details, these should not be construed as limitations on the scope of any invention or on the scope of what may be claimed, but rather as descriptions of features that may be specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially be claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

Particular embodiments of the subject matter have been described. Other embodiments are within the scope of the following claims.

### EMBODIMENTS

Although the present invention is defined in the attached claims, it should be understood that the present invention can also (alternatively) be defined in accordance with the following embodiments:
1. A vehicle camera system comprising:
   one or more camera components;
   heat generating electronic components; and
   a shroud configured to provide structural support for the one or more camera components and configured to facilitate dissipation of heat generated by the heat generating electronic components, the shroud including:
      boundaries at least partially surrounding the heat generating electronic components and defining a heat dissipation path for air flow from at least one air inlet to an air outlet of the shroud; and
      mounting features for mounting the one or more camera components, wherein at least one of the mounting features is defined within a portion of the boundaries defining the heat dissipation path.
2. The vehicle camera system of embodiment 1, comprising an enclosure configured to house the shroud, wherein the shroud is separated from at least a portion of an inner surface of the enclosure by a gap.
3. The vehicle camera system of embodiment 2, wherein the gap separating the shroud and the inner surface of the enclosure forms at least a portion of the heat dissipation path.
4. The vehicle camera system of embodiment 2, the at least one air inlet is located on a first region of the shroud, and the air outlet is located on a second region below a connecting member of the shroud, wherein the enclosure further comprises one or more venting apertures configured to cover at least a portion of the least one air inlet and air outlet to allow air flow through.
5. The vehicle camera system of embodiment 1, comprising a windshield mount configured to attach the vehicle camera system to a windshield of a vehicle, wherein the windshield mount is coupled to the shroud through a coupling mechanism, wherein the coupling mechanism comprises a first connecting element located on the shroud and configured to couple with a second connecting element located on the windshield mount.
6. The vehicle camera system of embodiment 1, comprising a fan configured to drive the air flow along a direction from the at least one air inlet to the air outlet along the heat dissipation path.
7. The vehicle camera system of embodiment 6, wherein the fan is disposed in a cavity of the shroud and located adjacent to the air outlet of the shroud.
8. The vehicle camera system of embodiment 1, wherein the shroud surrounds one or more heatsink elements disposed in a respective cavity defined in the shroud along the heat dissipation path, wherein the one or more heatsink elements are configured to distribute heat produced by the heat generating electronic components.
9. A vehicle camera system comprising:
   a support structure configured to hold one or more image sensors;
   a windshield mount;
   a connecting member configured to couple the support structure to the windshield mount in a plurality of possible orientations of the support structure relative to the windshield mount, wherein the connecting member comprises:
      a first connecting element located on the support structure, and a second connecting element located on the windshield mount configured to couple with the first connecting element; and
      a locking element configured to resist a change in an orientation of the support structure relative to the windshield mount; and
   an adjusting element configured to adjust a threshold torque value for resisting the change in an orientation of the support structure relative to the windshield mount from one of the plurality of possible orientations to another of the plurality of possible orientations.
10. The vehicle camera system of embodiment 9, wherein the support structure is inside a housing covering the support structure, wherein the support structure is separated from at least a portion of an inner surface of the housing by a gap.
11. The vehicle camera system of embodiment 9, wherein the locking element comprises a friction-based locking mechanism.
12. The vehicle camera system of embodiment 9, wherein the locking element comprises a first locking component arranged at the first connecting element, and a second locking component arranged at the second connecting element, wherein the first and second locking components are configured to engage to rotationally lock the first and second connecting elements with the threshold torque value.
13. The vehicle camera system of embodiment 12, wherein the first locking component comprises a first plurality of teeth and the second locking component comprises a second plurality of teeth, wherein the first plurality of teeth and the second plurality of teeth are configured to engage to form a clutch-type engagement that rotationally locks the first and second connecting elements with the threshold torque value.
14. The vehicle camera system of embodiment 12, wherein the adjusting element comprises a knob with one or more extrusions extending from an outer surface of the adjusting element, wherein the knob, when rotated, is configured to change a pressure applied on the first connecting element and the second connecting element to permit changing of the threshold torque value for rotating the first connecting element relative to the second connecting element.
15. The vehicle camera system of embodiment 14, wherein the first connecting element includes a first inner opening, wherein the second connecting element includes a second inner opening, wherein at least one of the first and second inner openings comprises a first thread configured to interface with a second thread of a lead screw of the adjusting element to form a threaded interface.
16. The vehicle camera system of embodiment 15, wherein the knob, when rotated, is configured to drive the lead screw along an axial direction of the lead screw relative to the first and second inner openings through the threaded interface.
17. The vehicle camera system of embodiment 16, wherein the adjusting element is configured to adjust the pressure applied on the locking element based on a relative axial position of the lead screw and the first and second inner openings through the threaded interface.
18. The vehicle camera system of embodiment 9, wherein the adjusting element includes a nut having at least one extrusion extending radially outward at an end of the nut, wherein the at least one extrusion of the nut is configured to couple with at least one aperture of a knob.
19. A vehicle camera system comprising:
   an image sensor;
   one or more light sources; and
   an enclosure configured to house the one or more light sources and the image sensor, the enclosure comprising:
      a central opening located on the enclosure and configured to pass light to the image sensor; and
      one or more surrounding openings located at an outside periphery of the central opening on the enclosure, wherein each of the one or more surrounding openings is configured to pass a respective light beam generated by at least one of the one or more light sources,
   wherein at least one of the one or more surrounding openings has a fillet or chamfer on an external surface of the enclosure, the fillet or chamfer forming an inner edge of the at least one surrounding opening that does not interfere with a light beam generated by a corresponding light source of the one or more light sources.
20. The vehicle camera system of embodiment 19, wherein the one or more surrounding openings are arranged to prevent respective light beams generated by the one or more light sources from being reflected into a field of view of the image sensor through the central opening.
21. The vehicle camera system of embodiment 19, wherein the one or more light sources are infrared (IR) light-emitting diodes (LEDs).
22. The vehicle camera system of embodiment 21, wherein the one or more surrounding openings comprise four surrounding openings, each having a diameter smaller than a diameter of the central opening.
23. The vehicle camera system of embodiment 19, further comprises an array of openings located above the central opening closer to another end of the enclosure, wherein the array of openings each are configured to receive a respective control button for controlling the vehicle camera system.

## Claims

1. A vehicle camera system comprising:
an image sensor;
one or more light sources (440); and
an enclosure (121) configured to house the one or more light sources and the image sensor, the enclosure comprising:
a central opening (420) located on the enclosure and configured to pass light to the image sensor; and
one or more surrounding openings (430) located at an outside periphery of the central opening on the enclosure, wherein each of the one or more surrounding openings is configured to pass a respective light beam generated by at least one of the one or more light sources,
wherein at least one of the one or more surrounding openings (430) has a fillet or chamfer (470) on an external surface (480) of the enclosure, the fillet or chamfer forming an inner edge of the at least one surrounding opening that does not interfere with a light beam generated by a corresponding light source of the one or more light sources.

2. The vehicle camera system of claim 1, wherein the one or more surrounding openings are arranged to prevent respective light beams generated by the one or more light sources from being reflected into a field of view of the image sensor through the central opening.

3. The vehicle camera system of claim 1 or 2, wherein the one or more light sources are infrared (IR) light-emitting diodes (LEDs), and optionally wherein the one or more surrounding openings comprise four surrounding openings, each having a diameter smaller than a diameter of the central opening.

4. The vehicle camera system of any one of claims 1 to 3, wherein:
the image sensor is one or more camera components; and
the vehicle camera system further comprises
heat generating electronic components; and
a shroud (200) configured to provide structural support for the one or more camera components and configured to facilitate dissipation of heat generated by the heat generating electronic components, the shroud including
boundaries at least partially surrounding the heat generating electronic components and defining a heat dissipation path for air flow from at least one air inlet (212, 213) to an air outlet (211) of the shroud, and
mounting features (241, 243) for mounting the one or more camera components, wherein at least one of the mounting features is defined within a portion of the boundaries defining the heat dissipation path.

5. The vehicle camera system of claim 4, comprising an enclosure configured to house the shroud, wherein the shroud is separated from at least a portion of an inner surface of the enclosure by a gap (290), and
optionally wherein the gap separating the shroud and the inner surface of the enclosure forms at least a portion of the heat dissipation path.

6. The vehicle camera system of claim 5, the at least one air inlet is located on a first region of the shroud, and the air outlet is located on a second region below a connecting member of the shroud, wherein the enclosure further comprises one or more venting apertures configured to cover at least a portion of the least one air inlet and air outlet to allow air flow through.

7. The vehicle camera system of claim 4, comprising a windshield mount (110) configured to attach the vehicle camera system to a windshield of a vehicle, wherein the windshield mount is coupled to the shroud through a coupling mechanism, wherein the coupling mechanism comprises a first connecting element located on the shroud and configured to couple with a second connecting element located on the windshield mount (110).

8. The vehicle camera system of claim 4, comprising a fan configured to drive the air flow along a direction from the at least one air inlet to the air outlet along the heat dissipation path, and
optionally wherein the fan is disposed in a cavity of the shroud and located adjacent to the air outlet of the shroud.

9. The vehicle camera system of any one of claims 1 to 3, comprising:
a support structure (200) configured to hold one or more image sensors;
a windshield mount (110);
a connecting member configured to couple the support structure to the windshield mount in a plurality of possible orientations of the support structure relative to the windshield mount, wherein the connecting member comprises:
a first connecting element located on the support structure, and a second connecting element located on the windshield mount configured to couple with the first connecting element; and
a locking element configured to resist a change in an orientation of the support structure (200) relative to the windshield mount; and
an adjusting element (118) configured to adjust a threshold torque value for resisting the change in an orientation of the support structure relative to the windshield mount from one of the plurality of possible orientations to another of the plurality of possible orientations.

10. The vehicle camera system of claim 9, wherein the enclosure (121) is a housing covering the support structure in which the support structure (200) is inside, wherein the support structure is separated from at least a portion of an inner surface of the housing by a gap (290).

11. The vehicle camera system of claim 9, wherein the locking element comprises a friction-based locking mechanism.

12. The vehicle camera system of claim 9, wherein the locking element comprises a first locking component arranged at the first connecting element, and a second locking component arranged at the second connecting element, wherein the first and second locking components are configured to engage to rotationally lock the first and second connecting elements with the threshold torque value.

13. The vehicle camera system of claim 12, wherein the first locking component comprises a first plurality of teeth and the second locking component comprises a second plurality of teeth, wherein the first plurality of teeth and the second plurality of teeth are configured to engage to form a clutch-type engagement that rotationally locks the first and second connecting elements with the threshold torque value.

14. The vehicle camera system of claim 12, wherein the adjusting element (118) comprises a knob (340) with one or more extrusions (346) extending from an outer surface of the adjusting element, wherein the knob, when rotated, is configured to change a pressure applied on the first connecting element and the second connecting element to permit changing of the threshold torque value for rotating the first connecting element relative to the second connecting element.

15. The vehicle camera system of claim 14, wherein the first connecting element includes a first inner opening, wherein the second connecting element includes a second inner opening, wherein at least one of the first and second inner openings comprises a first thread configured to interface with a second thread of a lead screw of the adjusting element to form a threaded interface, wherein the knob (340), when rotated, is configured to drive the lead screw along an axial direction of the lead screw relative to the first and second inner openings through the threaded interface, and
optionally wherein the adjusting element is configured to adjust the pressure applied on the locking element based on a relative axial position of the lead screw and the first and second inner openings through the threaded interface.
